# EUROPÄISCHE PATENTANMELDUNG

(11) **EP 1 388 911 A1**
(43) Veröffentlichungstag der Anmeldung: **11.02.2004**
(21) Anmeldenummer: 03017949.3
(22) Anmeldetag: 06.08.2003
(51) Int. Cl.: H01R 12/10

(54) **Verbund von zumindest zwei Folienleitungen und Verfahren zum elektrischen Kontaktieren von zumindest zwei Folienleitungen**

(30) Priorität: 10.08.2002 DE 10236776
(71) Anmelder: LEONI Bordnetz-Systeme GmbH & Co KG, 90402 Nürnberg (DE)
(72) Erfinder: Ott, Martin, 97320 Sulzfeld am Main (DE)
(74) Vertreter: Tergau & Pohl Patentanwälte

(57) **Zusammenfassung**

Zur elektrischen Verbindung zueinander korrespondierender Leiterbahnen (6) zweier Folienleitungen (2A,2B) ist die Anordnung einer Kontaktierungsmaske (4) zwischen den beiden Folienleitungen (2A,2B) vorgesehen. Die Kontaktierungsmaske (4) weist Kontaktfenster (12) auf, in deren Bereich die jeweiligen Leiterbahnen (6) miteinander kontaktiert sind. Die Verwendung der Kontaktierungsmaske (4) ermöglicht ein einfaches und damit kostengünstiges Positionieren der Folienleitungen (2A,2B) zueinander. Zudem können die Leiterbahnen (6) großflächig abisoliert werden.

## Beschreibung

Die Erfindung betrifft einen Verbund von zumindest zwei Folienleitungen, die in einem Verbindungsbereich elektrisch miteinander kontaktiert sind. Die Erfindung betrifft weiterhin ein Verfahren zur Ausbildung eines solchen Verbundes.

Unter Folienleitung wird allgemein eine Leitung verstanden, bei der mehrere flächige Leiterbahnen, insbesondere Kupferleiterbahnen, nebeneinander angeordnet und auf oder in einem folienartigen Trägermaterial aufgebracht bzw. eingebettet sind. Eine derartige Folienleitung wird beispielsweise durch einen Laminierprozess oder auch durch Extrusion hergestellt. Folienleitungen finden insbesondere im Kraftfahrzeugbereich vermehrt Einsatz, da sie aufgrund ihres folienartigen Charakters und ihrer nur geringen Dicke flexibel zu verlegen sind, ohne dass sie einen großen Einbauraum in Anspruch nehmen.

Beim Aufbau eines Kraftfahrzeug-Bordnetzes müssen einander zugeordnete Leiterbahnen unterschiedlicher Folienleitungen elektrisch miteinander kontaktiert werden. Bei der Ausbildung eines Bordnetzes oder bei der Verbindung mehrerer Folienleitungen wird gegenwärtig üblicherweise derart vorgegangen, dass zunächst die als Meterware vorliegende Folienleitung auf das benötigte Maß abgelängt wird. Im Verbindungsbereich, in dem die Kontaktierung mit einer weiteren Folienleitung erfolgen soll, werden die zueinander korrespondierenden Leiterbahnen freigelegt, indem in die Isolierung der Folienleitung Kontaktfenster beispielsweise durch mechanisches Abtragen oder durch Laserabtragen des Isolationsmaterials eingebracht werden. In der zweiten Folienleitung werden korrespondierend hierzu ebenfalls selektiv Kontaktfenster eingebracht. Anschließend werden die beiden Folienleitungen übereinander gelegt, so dass die im Bereich der Kontaktfenster freigelegten Leiterbahnen sich überdecken und beispielsweise durch einen Schweißvorgang miteinander kontaktiert werden.

Um eine sichere Kontaktierung zu gewährleisten, ist hierbei eine sehr hohe Positioniergenauigkeit erforderlich. Dies betrifft einerseits die positionsgenaue Ausbildung der Kontaktfenster als auch die möglichst exakte Positionierung der beiden Folienleitungen zueinander. Das Erfordernis der hohen Positioniergenauigkeit verlangt jedoch bei Folienleitungen einen hohen Aufwand. Denn aufgrund der Herstellungsweise der Folienleitungen, beispielsweise durch einen Laminier- oder Extrusionsprozess, ist die relative Lage der einzelnen Leiterbahnen zueinander und zu der äußeren Begrenzung der Folienleitung nicht exakt vorgegeben und mit relativ großen Toleranzen behaftet. Insbesondere ist auch der Abstand der Leiterbahnen zu der äußeren Flachseite der Folienleitung nicht gleichbleibend. D.h. die Dicke der Isolationsschicht auf einer Leiterbahn variiert. Daher ist beim Freilegen der Kontaktfenster Sorgfalt geboten, um die Leiterbahn beim Abisolieren nicht zu schädigen.

Wegen dieser Lageungenauigkeit der Leiterbahnen ist es auch erforderlich, dass die Kontaktfenster nur eng begrenzt, also selektiv, ausgebildet sind, um zu vermeiden, dass ein Kontaktfenster zwei eng benachbarte Leiterbahnen überdeckt. Dies hat aber zugleich den Nachteil, dass beim Kontaktieren der einander zugeordneten Leiterbahnen diese im Bereich des Kontaktfensters relativ stark gebogen werden müssen und damit stark beansprucht werden, da die beiden zueinander korrespondierenden Leiterbahnen zum Kontaktieren über die Isolationsdicke der Isolierung hinweg gegeneinander gepresst werden müssen.

Aus der EP 1 107 374 A2 ist zur positionsgenauen Kontaktierung der Leiterbahnen zweier Leiterplatten ein von dem üblichen Kontaktierungsprinzip zur Verbindung der Leiterbahnen von Folienleitungen aubweichendes Kontaktierunsprinzip vorgesehen. Danach werden die endseitigen Kontaktflächen der auf der Leiterplatte angeordneten Leiterbahnen dreidimensional ausgebildet, so dass anhand des dreidimensionalen Musters die Positionierung erfolgen kann. Dieses Konzept ist jeodch zur Kontaktierung von als Meterware hergestellten Folienleitungen nicht geeignet, da an den Kontaktstellen in auwändiger Weise erst dreidimensionale Leiterbahnstrukturen nachträglich erzeugt werden müssten.

Der Erfindung liegt die Aufgabe zugrunde, die Kontaktierung zwischen zwei Folienleitungen zu verbessern.

Die Aufgabe wird gemäß der Erfindung gelöst durch einen Verbund von zumindest zwei mehrere Leiterbahnen aufweisende Folienleitungen, die in einem Verbindungsbereich übereinander liegen, wobei in diesem Verbindungsbereich zwischen den Folienleitungen eine Kontaktierungsmaske mit Kontaktfenstern angeordnet ist. Zueinander korrespondierende Leiterbahnen der Folienleitungen sind jeweils im Bereich eines jeweiligen Kontaktfensters aufeindander zugebogen und miteinander kontaktiert.

Dieser Ausgestaltung liegt die Überlegung zugrunde, die für die Positioniergenauigkeit erforderlichen Maßnahmen und Vorkehrungen im Wesentlichen nicht an der Folienleitung selbst vorzunehmen, sondern hierfür ein separates Einlegeteil, nämlich die Kontaktierungsmaske, vorzusehen. Die Kontaktierungsmaske ist beispielsweise eine Isolationsfolie, in die relativ einfach und präzise Kontaktfenster beispielsweise durch Stanzen eingebracht werden können. Die Herstellung der Kontaktierungsmaske ist daher sowohl einfach als auch kostengünstig. Von besonderem Vorteil ist, dass bei der Folienleitung die für die Kontaktierung der Leiterbahnen notwendige Abisolierung nicht mehr selektiv und hochgenau erfolgen muss, so dass einfache Maßnahmen zur Abisolierung ergriffen werden können, wodurch die Prozessgeschwindigkeit erheblich verbessert werden kann. Insgesamt wird durch die Verwendung der Kontaktierungsmaske ein einfacheres, schnelleres und kostengünstigeres Verbinden zweier Folienleitungen miteinander ermöglicht. Hierbei werden die abisolierten Bereiche der Folienleitungen unter Zwischenlegung der Kotaktierunsmaske mit den Kontaktfenstern übereinader gelegt.

Die abisolierten Leiterbahnen sind zunächst voneinander beabstandet, und zwar entspricht der Abstand der Dicke der Isolierung zuzüglich der Dicke der Maske. Zum Kontaktieren werden die Leiterbahnen im Bereich der Kontaktfenster aufeinander zugebogen, gegeneinader gepresst und beispielsweise durch Schweißen miteinander verbunden.

Da die Kontaktierungsmaske ein selektives Abisolieren der Leiterbahnen nicht erfordert, sind in einer bevorzugten Ausgestaltung die Folienleitungen im Verbindungsbereich großflächig abisoliert. Insbesondere erfolgt die Absisolierung über mehrere Leiterbahnen oder über die gesamte Breite der Folienleitung hinweg und ist beispielsweise in etwa an die Geometrie der Kontaktierungsmaske angepasst. Dieses großflächige Abisolieren kann relativ schnell und kostengünstig durch mechanisches Abtragen erfolgen. Dabei können auch Reste der Isolierung auf den Leiterbahnen zunächst in Kauf genommen werden, da diese durch geeignete Verfahren beim elektrischen Kontaktieren der Leiterbahnen, beispielsweise durch das so genannte Thermodenschweißen, entfernt werden können. Beim Thermodenschweißen werden die zum Schweißen herangezogenen Elektroden vor dem eigentlichen Schweißvorgang zunächst erhitzt, so dass ein eventuell noch auf der Leiterbahn befindlicher Isolationsfilm entfernt wird.

Vorzugsweise weist die Kontaktierungsmaske etwa eine Dicke zwischen 50 µm und 200 µm und insbesondere von etwa 100 µm auf. Damit ist eine ausreichende Isolationsdicke gegeben und es ist ein flacher Gesamtaufbau des Verbunds gewährleistet.

Die Kontaktierungsmaske besteht aus einem Isolationsmaterial und insbesondere aus dem gleichen Isolationsmaterial wie die Isolierung der Folienleitungen. Ein Vorteil der Ausbildung der Kontaktierungsmaske aus Isolationsmaterial besteht darin, dass die Isolationswirkung der Kontaktierungsmaske bei der Bemessung der Isolationsdicke bei den Folienleitungen berücksichtigt werden kann. Dies bedeutet, dass die Isolierung bei den Folienleitungen dünner ausgebildet werden kann, als wenn keine Kontaktierungsmaske verwendet wird. Dies führt zu einem geringeren Materialverbrauch und auch zu einer geringeren Gesamtdicke der Folienleitung bzw. des Verbunds aus den Folienleitungen.

Zweckdienlicherweise ist die Kontaktierungsmaske als ein Versteifungselement mit hoher Eigensteifigkeit ausgebildet, so dass die mechanische Widerstandsfähigkeit des Verbindungsbereichs positiv beeinflusst wird.

Um eine einfache Positionierung der Kontaktierungsmaske und der beiden Folienleitungen zueinander zu ermöglichen, ist in einer zweckdienlichen Weiterbildung die Kontaktierungsmaske zumindest an einer der Folienleitungen beispielsweise durch Kleben fixiert. Hierzu ist die Kontaktierungsmaske vorzugsweise mit einer Klebeschicht ausgebildet.

Bevorzugt weisen die Kontaktfenster eine größere Fläche auf als die Überlappfläche, in der sich die jeweiligen miteinander kontaktierten Leiterbahnen überdecken. Es besteht somit ein gewisser Spielraum der Positionierung der Kontaktierungsmaske, d.h. ihre Positionierung relativ zu den Folienleitungen weist einen gewissen Toleranzspielraum auf.

Die Aufgabe wird weiterhin gelöst durch ein Verfahren zum elektrischen Kontaktieren von korrespondierenden Leiterbahnen mit den Merkmalen des Patentspruchs 8.

Bevorzugte Weiterbildungen sind den Unteransprüchen zu entnehmen. Im Übrigen sind die bevorzugten Ausgestaltungen des Verbunds sowie die besonderen Vorteile sinngemäß auch auf das Verfahren zu übertragen.

Ein Ausführungsbeispiel der Erfindung wird im Folgenden anhand der Zeichnung näher erläutert. Es zeigen jeweils in schematischen Darstellungen:
- Fig. 1: eine Schnittansicht durch einen Verbund aus zwei Folienleitungen in einem Verbindungsbereich mit einer Kontaktierungsmaske in einem Montagezustand vor der Kontaktierung der zueinander korrespondierenden Leiterbahnen,
- Fig. 2: eine Schnittansicht durch einen Verbund aus zwei Folienleitungen während des Kontaktierungsvorgangs der zueinander korrespondierenden Leiterbahnen,
- Fig. 3a-3d: eine Aufsicht auf die beiden zu verbindenden Folienleitungen und die Kontaktierungsmaske in unterschiedlichen Verfahrensstufen,
- Fig. 4a: eine Schnittansicht durch einen Verbund von zwei Folienleitungen beim herkömmlichen Kontaktieren ohne Kontaktierungsmaske und
- Fig. 4b: eine Aufsicht auf zwei Folienleitungen mit herkömmlich angeordneten, selektiven Kontaktfenstern vor der Kontaktierung.

Einander entsprechende Teile sind in den einzelnen Figuren mit denselben Bezugszeichen versehen.

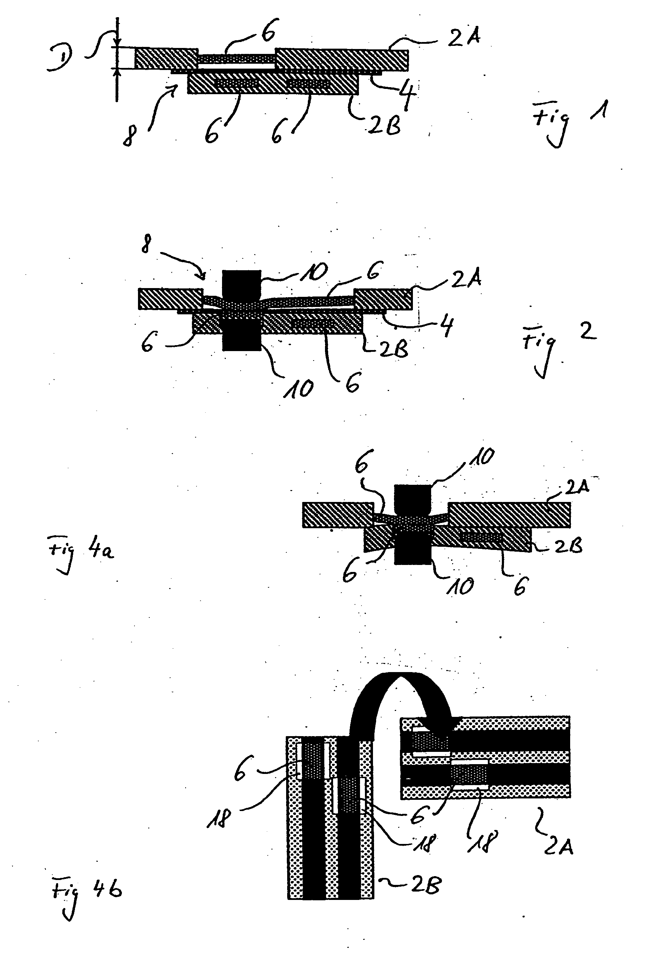

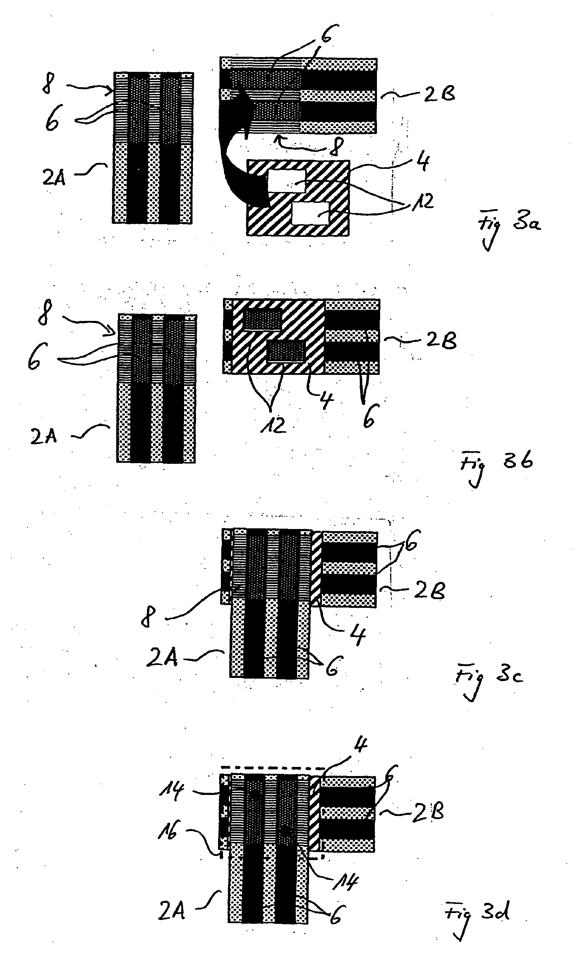

Gemäß den Fig. 1 und 2 bilden eine erste, obere Folienleitung 2A, eine zweite, untere Folienleitung 2B sowie eine Kontaktierungsmaske 4 einen Verbund. Die beiden jeweils nur ausschnittsweise dargestellten Folienleitungen 2A,2B liegen dabei unter Einschluss der Kontaktierungsmaske 4 übereinander. Die Folienleitungen 2A,2B weisen im Ausführungsbeispiel jeweils zwei Leiterbahnen 6 auf. Der Bereich, in dem sich die beiden sich kreuzenden oder T-förming angeordneten Folienleitungen 2A,2B überdecken, definiert einen Verbindungsbereich 8, innerhalb dessen die jeweils zueinander korrespondierenden Leiterbahnen 6 der ersten Folienleitung 2A mit denen der zweiten Folienleitung 2B kontaktiert werden.

Innerhalb dieses Verbindungsbereichs 8 sind die Leiterbahnen 6 insbesondere großflächig freigelegt. Hierzu wird beispielsweise das Isolationsmaterial beidseitig der Leiterbahnen 6 mittels eines mechanischen Verfahrens über die gesamte Breite der Folienleitungen 2A,2B abgetragen. Es ist unschädlich, wenn dabei Zwischenstege zwischen den Leiterbahnen 6 stehen bleiben.

In Fig. 2 ist eine besonders großflächige Abisolierung vorgenommen mit einer im Vergleich zu der Ausführung nach Fig. 1 größeren Längenausdehnung in Längsrichtung der Folienleitungen 2A,2B. Beim Verbinden der Leiterbahnen 6, beispielsweise durch einen Schweißvorgang, werden die beiden Leiterbahnen durch Elektroden 10 gegeneinander gepresst und miteinander verschweißt. Dabei werden die Leiterbahnen 6 zwangsläufig verbogen. Aufgrund der großflächigen Abisolierung weisen sie im Vergleich zu den herkömmlichen Verfahren ohne Kontaktierungsmaske (vgl. hierzu Fig. 4a,4b) nur einen vergleichsweise geringen Krümmungsradius auf, so dass die Belastung der Leiterbahnen 6 gering bleibt.

Beim Ausführungsbeispiel ist die Gesamtdicke D der jeweiligen Folienleitung 2A,2B geringer gewählt als bei Folienleitungen, die herkömmlich ohne Kontaktierungsmaske 4 miteinander verbunden werden. Die Gesamtdicke D einer herkömmlichen Folienleitung beträgt beispielsweise üblicherweise 600 µm, wobei hiervon jeweils etwa 200 µm auf die Leiterbahn 6 und auf die untere und obere Isolationsschicht entfallen. Bei der Verwendung der Kontaktierungsmaske 4 ist die Gesamtdicke D demgegenüber zweckdienlicherweise reduziert, beispielsweise um 100 µm auf 500 µm. Diese Reduzierung ist ohne weiteres möglich, da die Kontaktierungsmaske 4, die insbesondere als eine Isolationsfolie ausgebildet ist, zur Isolationswirkung beiträgt. Durch die Reduzierung der Gesamtdicke D wird zudem der Abstand zwischen den beiden miteinander zu kontaktierenden Leiterbahnen 6 trotz zusätzlicher Anordnung der Kontaktierungsmaske 4 möglichst gering gehalten, so dass keine übermäßige Biegung der Leiterbahnen 6 beim Kontaktieren erforderlich ist. Bei einer Gesamtdicke D von 500 µm weist die Folienleitung 2A,2B beidseitig der Leiterbahnen 6 durchschnittlich jeweils eine Isolationsdicke von etwa 150 µm auf. Bei einer geeigneten Dicke der Kontaktierungsmaske von etwa 100 µm ergibt sich hierdurch ein Abstand der kontaktierenden Leiterbahnen von etwa 400 µm. Dies entspricht dem Abstand, der auch ohne Kontaktierungsmaske 4 und bei einer Gesamtdicke von 600 µm vorliegt.

Zur Ausbildung des Verbunds wird in mehreren Schritten vorgegangen, wie anhand der Fig. 3a bis 3d illustriert wird. Zunächst werden die Leiterbahnen 6 großflächig im Verbindungsbereich 8 freigelegt, also abisoliert, und die Kontakierungsmaske 4 mit Kontaktfenstern 12 bereitgestellt. Im Ausführungsbeispiel sind die Kontaktfenster 12 diagonal versetzt zueinander angeordnet, wobei sie sich in einem Teilbereich überlappen. Die Kontaktfenster 12 werden beispielsweise in einfacher Weise durch Ausstanzen mit ausreichender Positionsgenauigkeit in die Kontaktierungsmaske 4 eingebracht. Die Kontaktierungsmaske 4 ist beispielsweise als eine Klebefolie ausgebildet, die bevorzugt beidseitig mit einer Klebeschicht versehen ist. Die Konaktierungsmaske 4 kann auch als ein Versteifungselement mit hoher Eigensteifigkeit ausgebildet sein und hierzu ein relativ unflexibles Kunststoffmaterial aufweisen.

Im anschließenden Schritt (Fig. 3b) wird - wie durch den Pfeil in Fig. 3a angedeutet - die Kontaktierungsmaske 4 auf der unteren Folienleitung 2B positioniert und fixiert, so dass die Kontaktierungsmaske 4 nicht verrutscht. Die Kontaktfenster 12 überdecken dabei die jeweiligen Leiterbahnen 6, wobei die Kontaktfenster 12 etwas breiter als die Leiterbahnen 6 sind. Auch ist die Länge der Kontaktfenster 12 größer als die Breite der Leiterbahnen 6, so dass die Kontaktierungsmaske 4 innerhalb eines gewissen Toleranzbereiches auf die untere Folienleitung 2B aufgebracht werden kann. Zugleich kann auch die obere Folienleitung 2A in einem Toleranzbereich insbesondere in Längsrichtung der unteren Folienleitung 2B verschoben werden. Insgesamt ist daher eine relativ einfache Positionierung ermöglicht. Durch das im nächsten Schritt (Fig. 3c) erfolgende Auflegen der oberen Folienleitung 2A werden die jeweiligen zueinander korrespondierenden Leiterbahnen 6 im Bereich der Kontaktfenster 12 zur Überdeckung gebracht. Durch die vorzugsweise beidseitig angebrachte Klebeschicht auf der Kontaktierungsmaske 4 ist bereits in diesem Zustand ein Verrutschen der Folienleitungen 2A,2B relativ zueinander und relativ zur Kontaktierungsmaske 4 ausgeschlossen. Der Verbund ist also zueinander fixiert. Im letzten Verfahrensschritt werden dann die zueinander korrespondierenden Leiterbahnen 6 miteinander elektrisch kontaktiert. In Fig. 3d ist dies jeweils durch einen Kontaktschweißpunkt 14 dargestellt. Durch die Fixierung des Verbunds über die Kontaktierungsmaske 4 sind in vorteilhafter Weise die Kontaktschweißpunkte 14 im Wesentlichen frei von mechanischen Kräften. Es ist also eine wirksame Zugentlastung geschaffen. In einem anschließenden Schritt wird üblicherweise der Verbindungsbereich noch mit einer Schutzabdeckung 16, die lediglich gestrichelt angedeutet ist, überdeckt. Diese Schutzabdeckung 16 ist beispielsweise eine Isolationsfolie oder kann auch durch ein Isolationsspray aufgebracht werden.

Die Vorteile der Verwendung der Kontaktierungsmaske 4 ergeben sich insbesondere bei einem Vergleich mit dem herkömmlichen Vorgehen ohne Verwendung der Kontaktierungsmaske 4. Wie aus Fig. 4b ersichtlich, sind herkömmlich nämlich selektive und hochpräzise Kontaktfenster, im Folgenden als Kontaktaussparungen 18 bezeichnet, unmittelbar in die Isolierung der Folienleitungen 2A,2B eingebracht. Aus Gründen der Kontaktsicherheit überlappen sich diese in Längsrichtung der jeweiligen Folienleitungen 2A,2B gesehen nicht. Aufgrund der herstellungsbedingten hohen Lageungenauigkeit der Leiterbahnen 6 relativ zueinander und relativ zu der Außenkante der Folienleitungen 2A,2B erfordert diese selektive Anordnung der Kontaktaussparungen 18 einen großen und insbesondere zeitintensiven Aufwand. Die beiden Leiterbahnen 2A,2B müssen - wie durch den Pfeil angedeutet - positionsgenau übereinander gelegt werden, so dass sich die jeweiligen entsprechenden Kontaktaussparungen 18 exakt überlappen. Aufgrund der zwangsweise geringen Fläche der Kontaktaussparung 18 ist zudem eine erhebliche Durchbiegung der Leiterbahnen erforderlich, um die zueinander korrespondierenden Leiterbahnen miteinander kontaktieren zu können, wie aus Fig. 4a ersichtlich ist.

### Bezugszeichenliste

- 2A: erste Folienleitung
- 2B: zweite Folienleitung
- 4: Kontaktfenster
- 6: Leiterbahn
- 8: Verbindungsbereich
- 10: Elektrode
- 12: Kontaktfenster
- 14: Kontaktschweißpunkt
- 16: Schutzabdeckung
- 18: Kontaktaussparung

- D: Gesamtdicke

## Patentansprüche

1. Verbund von zumindest zwei mehrere Leiterbahnen (6) aufweisende Folienleitungen (2A,2B), die in einem Verbindungsbereich (8) übereinander liegen, wobei im Verbindungsbereich (8) zwischen den Folienleitungen (2A,2B) eine Kontaktierungsmaske (4) mit Kontaktfenstern (12) angeordnet ist und zueinander korrespondierende Leiterbahnen (6) der Folienleitungen (2A,2B) jeweils im Bereich eines jeweiligen Kontaktfensters (12) aufeinander zugebogen und miteinander kontaktiert sind.

2. Verbund nach Anspruch 1, bei dem die Folienleitungen (2A,2B) im Verbindungsbereich (8) großflächig abisoliert sind.

3. Verbund nach Anspruch 1 oder 2, bei dem die Kontaktierungsmaske (4) eine Dicke zwischen 50 µm und 200 µm, insbesondere von etwa 100 µm, aufweist.

4. Verbund nach einem der vorhergehenden Ansprüche, bei dem die Kontaktierungsmaske (4) als Versteifungselement mit hoher Eigensteifigkeit ausgebildet ist.

5. Verbund nach einem der vorhergehenden Ansprüche, bei dem die Kontaktierungsmaske (4) zumindest an einer der Folienleitungen (2A,2B) fixiert ist.

6. Verbund nach Anspruch 5, bei dem die Kontaktierungsmaske (4) mit einer Klebeschicht ausgebildet ist.

7. Verbund nach einem der vorhergehenden Ansprüche, bei dem die Kontaktfenster (12) eine größere Fläche aufweisen als die Überlappfläche, in der sich die jeweiligen miteinander kontaktierten Leiterbahnen (6) überdekken.

8. Verfahren zum elektrischen Kontaktieren von korrespondierenden Leiterbahnen (6) von zumindest zwei Folienleitungen (2A,2B), wobei in einem Verbindungsbereich (8) die Leiterbahnen (6) abisoliert werden, zwischen den Folienleitungen (2A,2B) im Verbindungsbereich (8) eine Kontaktierungsmaske (4) mit Kontaktfenstern (12) angeordnet wird und die korrespondierenden Leiterbahnen (6) im Bereich der Kontaktfenster (12) aufeinander zugebogen und miteinander kontaktiert werden.

9. Verfahren nach Anspruch 9, bei dem die Folienleitungen (2A,2B) im Verbindungsbereich (8) großflächig abisoliert werden.

10. Verfahren nach Anspruch 8 oder 9, bei dem die Kontaktierungsmaske (4) zunächst relativ zu der ersten Folienleitung (2A) positioniert und fixiert wird, und dass anschließend die zweite Folienleitung (2B) aufgelegt wird.
